**Europäisches Patentamt**

**European Patent Office**

**Office européen des brevets**

(19)

(11) Publication number: **0 090 613**
**B1**

(12) # EUROPEAN PATENT SPECIFICATION

(45) Date of publication of patent specification: **01.02.89**

(51) Int. Cl.⁴: **H 01 L 39/24, H 01 L 21/00**

(21) Application number: **83301678.5**

(22) Date of filing: **25.03.83**

(54) Improvements in methods of making layered electrical devices.

(30) Priority: **26.03.82 US 362577**

(43) Date of publication of application:
**05.10.83 Bulletin 83/40**

(45) Publication of the grant of the patent:
**01.02.89 Bulletin 89/05**

(84) Designated Contracting States:
**CH DE FR GB IT LI NL**

(56) References cited:
**US-A-4 218 532**
**US-A-4 256 816**

**IBM TECHNICAL DISCLOSURE BULLETIN, vol.
17, no. 8, January 1975, page 2446, New York,
US; R.F. BROOM: "Making Josephson tunnel
junctions"**

(73) Proprietor: **SPERRY CORPORATION**
**1290, Avenue of the Americas**
**New York, N.Y. 10019 (US)**

(72) Inventor: **Lung-Chung-Young, Peter, Dr.**
**224 Old Church Road**
**North Wales Pennsylvania 19454 (US)**

(74) Representative: **Orchard, Oliver John**
**JOHN ORCHARD & CO. Staple Inn Buildings**
**North High Holborn**
**London WC1V 7PZ (GB)**

Courier Press, Leamington Spa, England.

## Description

This invention relates to a method of making Josephson junction devices or semiconductor devices. More particularly, the present invention provides a method of controlling the angle at the edges of vacuum deposited materials so that vertical steps and negative steps are eliminated and replaced by gentle slope changes.

Deposition of layers of metals and insulating materials by evaporation in a vacuum chamber are known techniques employed to make Josephson junction devices and semiconductor devices. Materials to be deposited are placed in a boat or a container and are heated in a high vacuum until evaporation of the material occurs. The wafer or the substrate which is being processed is placed at a distance from the source of material. The atoms and molecules of the evaporated materials travel from the source to the wafer in a straight line, and are built up as a layer over the wafer as well as the surrounding equipment in the vacuum chamber.

Photoresist patterns can be made which have a larger exposed area at the base on the wafer than at the top of the photoresist exposed to the evaporation of material, i.e. the photoresist pattern is undercut at the top surface and provides an offset ledge. Such photoresist stencils which have offset ledges are referred to as lift-off photoresist patterns. When evaporated material is deposited over such lift-off patterns, the top edge of the lift-off pattern defines an aperture through which the evaporated material is deposited on the area of the wafer exposed to the line of sight of the evaporated material. Thus, it is possible to generate on the same area being deposited a positive slope at one edge and a negative slope at the other edge.

When a small wafer is placed in a vacuum chamber at a substantial distance from the source of the evaporating material, the layer being deposited will have substantially vertical edge walls. If the wafer is large and/or the distance to the source of the evaporating material is small, there is a large angular deviation from the vertical or normal axis line of sight. When this deviation angle begins to exceed ten degrees, portions of the deposited material will have a positive slope at one edge and other portions at the opposite side of the wafer will have a negative slope.

Negative slope at the edge of deposited layers causes cracks in the insulation and voids at the undercut areas of the negative slope, resulting in improper insulation and/or discontinuities between the subsequent layers deposited on top of the negative slope edge.

It has been proposed to mount large substrates and wafers on rotary supports so that the portions of the wafer subject to the largest deviation angle is rotated closer to the normal axis during a portion of the deposition time. Rotating and evaporating at oblique angles tends to decrease the negative slope of deposited layers when small wafers are being processed, but it does not solve the negative slope problem when applied to large wafers, and the support means employed to provide this movement makes it extremely difficult, if not impossible, to cool the substrate to the very low temperatures that are often required in the manufacture of Josephson junction devices.

It is an object of the present invention to provide a method of making layered electrical devices having a controlled positive slope at the edges of a layer.

A positive slope occurs when the top surface of the layer being deposited is smaller than the base of the layer being deposited so that the slope or step edge is gradually inclined.

In the method of the invention as claimed in claim 1 a lift-off overhang stencil defines the edges of a layer to be applied. An inert gas is introduced into the vacuum chamber, to a suitable pressure, and the evaporated atoms and molecules collide with the inert gas atoms causing the apparent source of the evaporated material to appear extended across a broad area of the vacuum chamber rather than being a single point. Deposition occurs under the overhang of the lift-off photoresist stencil to provide a positive gentle slope step change instead of a vertical step or a negative slope step.

The carrying out of the invention will now be described by way of example with reference to the accompanying drawings, in which

Figure 1 is an enlarged partial cross-section of a wafer on which electrode material is being deposited in a vacuum chamber, employing prior art techniques;

Figure 2 is an enlarged partial cross-section of one of the electrodes of Figure 1 after a plurality of layers have been deposited thereon;

Figure 3 is an enlarged partial cross-section of another of the electrodes of Figure 1 after a plurality of layers have been deposited thereon;

Figure 4 is an enlarged partial cross-section showing an electrode after a plurality of layers have been deposited thereon by the method of the invention;

Figure 5 is an enlarged partial cross-section of the edge of the lift-off photoresist stencil adjacent to the electrode of Figure 4 after deposition of the electrode;

Figure 6 is a graph showing the relationship between gas pressure and the positive slope obtained during the deposition of lead-indium-gold alloy in the presence of argon; and

Figure 7 is a table showing the average number of collisions between the evaporated material and the argon atoms at different argon pressures.

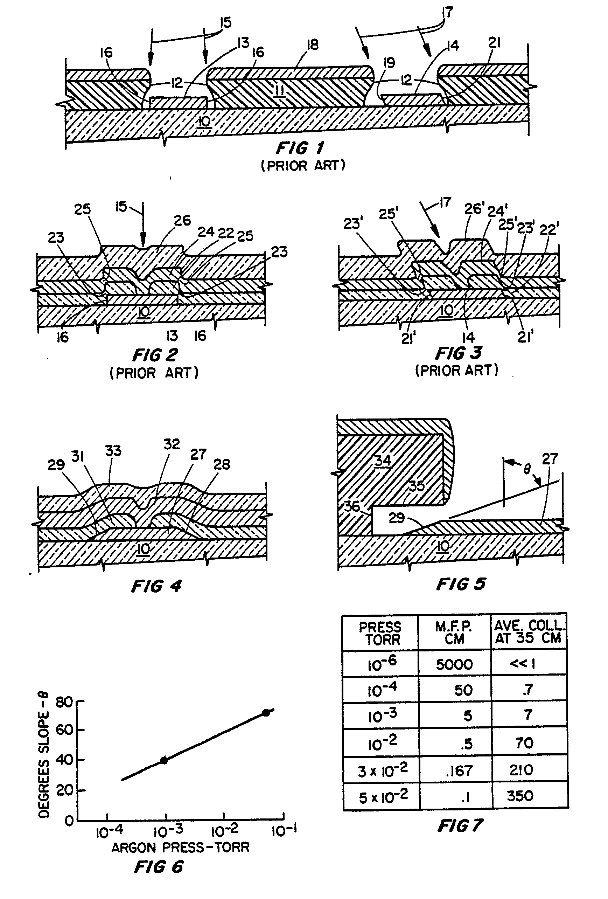

Figure 1 shows an enlarged diagrammatic cross-section in of a portion of a wafer 10 on which a photoresist pattern or stencil 11 has been formed according to the prior art. The stencil 11 has lift-off pattern apertures 12 therein which define the open area in which material will be deposited in a vacuum chamber to form the electrodes 13 and 14. The arrows 15 define the line of sight from the source point of a material being evaporated in a vacuum chamber (not shown). When the atoms and molecules are deposited in a high vacuum system, the line of sight 15 from the source determines the direction in which deposition occurs. The atoms and molecules deposit on top of the photoresist pattern 11 as well as through the aperture 12 to form the electrode 13. When the line of sight is normal to the surface plane of the substrate or wafer 10, the sides of the electrode 13 are substantially vertical, in alignment with the line of sight arrows 15. It will be noted that there is no undercut at the edge 16 of the electrode 13.

If the wafer is large, the electrode 14 presents a more oblique line of sight 17 so that the material being deposited through the aperture 12 to form the electrode 14 will form a negative slope step 19 at one edge and a positive slope step 21 at the other.

Figure 2 shows the base electrode 13 on the substrate 10 after the photoresist material 11 has been removed and after additional layers have been deposited to form a Josephson junction device. The first layer 22 is an insulation layer formed by evaporation and deposition at a line of sight angle 15 substantially normal to the plane of the substrate 10. The insulation layer 22 is preferably of silicon oxide, and is equal to or thicker than the base electrode 13. It will be noted that the material forms in such a manner that the thickness of the insulation layer 22 at the top of the step edge is much thinner than the other portions of the insulation layer 22.

This thin insulation at point 23 creates a stress area which easily cracks and destroys the usefulness of the Josephson junction device. On the insulation layer 22 there is a counter electrode 24 which is approximately equal to or thicker than the insulation layer 22. Since the layer 24 is also formed as a uniform layer, a step occurs above the edge 16 which is not as abrupt as the step in the insulation layer 22 due to a smoothing effect during build-up. Thus, the critical region 25 between the insulation layer 22 and the counter electrode layer 24 is not as great as the stress area 23. It is possible, but not desirable, to increase the thickness of the counter electrode layer 24 to further increase the distance at the critical region 25. A passivation layer 26 is applied on top of the counter electrode layer 24 to provide insulation and protection to the Josephson junction device. Typically the passivation layer is much thicker than the insulation layer 22 and counter electrode layer 24, thus there is less possibility of creating a critical area over the step 16.

Refer now to Figure 3 showing electrode 14 after the removal of the photoresist stencil 11, and the material 18 thereon, and after the deposition of the three layers which form the Josephson junction device. The silicon oxide layer 22' is formed in the same manner as described hereinbefore and the same critical areas 23' are produced which correspond to the critical areas 23 of Figure 2. Due to the larger deviation of the line of sight 17 from the normal, the critical region 23' on the left side of the electrode 14 may be even smaller than the critical region 23 shown in Figure 2. When the counter electrode layer 24' is formed, the critical regions 25' are formed over the step edges 21'. The critical region 25' on the right side of the electrode 14 is smaller than the critical region 25' on the left side of electrode 14, due to the smoothing effect of the material being deposited. The passivation layer 26' is formed on top of the counter electrode 24' to a thickness which is sufficient to avoid stress regions that are more critical than those shown at regions 23' and 25'.

It is possible that the deposited material will not completely fill the space at the base of the negative slope 21' on the left side of the electrode 14, and a void in the insulation will occur at this point.

Since Josephson junction devices are cycled between room temperature and approximately four degrees Kelvin, the concentration of stress at voids, or at the thinning of the layers is sufficient to cause internal cracks and failure of the Josephson junction devices.

It will be understood that Figures 1 to 3 are schematic only, and have not been drawn to scale.

Figure 4 shows a base electrode 27 having symmetrical positive slopes 28 and 29. When the base elelctrode is made with gentle positive slopes, the subsequently deposited layers are substantially uniform replications of the contour of the base electrode 27, so that there is no thinning and stress concentration region as described above with reference to Figures 1 to 3 and the prior art. The insulation layer 31 is substantially uniform over the base electrode 27 and along the positive slopes 28, 29 as well as on top of the substrate 10. When the counter electrode 32 is formed on top of the insulation layer 31, there is a slight smoothing effect and the uniformity of the layer is even greater than with the insulation layer 31. Since the uniformity of the counter electrode layer 32 is already established, the passivation layer 33 may be made much thinner and stronger. It is well known that thick layers of passivation material 33 tends to promote stress concentrations, whereas thin layers are more immune to stresses due to thermal cycling.

Figure 5 shows an enlarged cross-section of portion of a photoresist stencil pattern 34 which has an overhang or ledge 35 extending laterally from the gap height 36. The base electrode 27 has a positive slope 29 under the ledge 35. The positive slope 29 is measured by the angle theta ($\theta$) from the vertical. It will be understood that if the angle was in the opposite direction, and sloping backwards as an undercut ledge, it would be negative.

Figure 6 is a graph of the positive slope $\theta$ versus the pressure of argon, when material is deposited from a point source in a vacuum chamber containing argon at low pressure. The vacuum chamber is first pumped down to a high vacuum of at least $10^{-6}$ torr (1 torr=133 Pa) for the most metal materials, and $10^{-5}$ torr for aluminium. After the high vacuum necessary is achieved, some inert gas is bled in to raise the pressure within the vacuum chamber to between $10^{-4}$ and $5 \times 10^{-2}$ torr, depending on the results desired. When the inert gas employed is argon, the graph of Figure 6 is applicable. If an angle theta (shown in Figure 5) of sixty degrees is desired, an argon pressure of $10^{-2}$ torr will be employed to produce this. The graph shown in Figure 6 was produced for deposition of lead-indium-gold base electrodes 27, and may differ slightly for other metals, or for other inert gases.

The reason for the formation of the positive slope is that collisions occur between the evaporated atoms and molecules and the atoms of the inert gas between the substrate 10 and the point source material. The mean free path (MFP) which defines the average distance which an atom will travel before it collides with another atom is denoted by the symbol L in centimeters. It is known that L is equal to $5 \times 10^{-3}$ divided by the argon pressure in torrs.

Figure 7 is a table in which the mean free path L in centimeters has been calculated for a number of pressures of argon gas. In the left hand column, the high vacuum pressure of $10^{-6}$ torr is substantially clean of contaminating gas, and no argon gas is present. Under these conditions the average number of collisions over a distance of thirty-five centimeters is much less than one. However, in an argon atmosphere of $10^{-4}$ torr, the mean free path is reduced to fifty centimeters and the average number of collisions over the distance between the material being evaporated and the substrate 10 is now approaching one. When the argon pressure in the vacuum chamber is stabilised at $10^{-3}$ torr, the mean free path has decreased to five centimeters, and approximately seven collisions occur to the atoms of the material being evaporated before reaching the substrate. It will be appreciated that seven collisions of atoms while travelling from the source of the material to the substrate 10 produces a scatter or dispersion effect so that the material no longer behaves as though it comes from a point source, but from an extended source which extends throughout the vacuum chamber. As the pressure of the inert argon gas increases, so does the positive slope angle theta.

Materials other than lead-indium-gold, and other inert gases, may be employed to accomplish the same results.

One of the important results of achieving positive slope and gentle step changes is that much higher yields of acceptable devices are obtained by the standard processes already commercially employed without any added cost. A further advantage of the present novel process is that the vacuum chamber may be filled with wafers without the requirement that they be in axial or normal alignment with the point source of material being evaporated. Thus, not only high yields, but much higher production rates, are achieved simultaneously.

It will be appreciated that the amount of positive slope between layers can be changed by controlling the inert gas pressure during the process of depositing layers.

The present process has another advantage for making custom devices. When custom devices are being manufactured, the vacuum chambers are usually relatively small, compared to very large vacuum chambers used for high volume commercial production. Employing the present invention, large wafers up to six inches (1 inch=2.54 cm) in diameter may be processed in a vacuum chamber where the distance from the source of evaporating material to the substrate is les than twelve inches, and the sight angle would be greater than ten degrees from a point source. The amount of symmetrical positive slope achieved on the layers can then be controlled by the inert gas pressure.

While the line width of very small conductive lines is increased to some extent by the present invention, the advantages far outweigh the disadvantages in most cases. For example, when a conductive line on an integrated circuit is to be crossed by another conductive line on an integrated circuit, points of stress concentration at the vertical steps are completely eliminated by employing gentle positive slope step changes.

## Claims

1. A method of making an electrical device by the deposition of layers of conductors and insulators on a substrate in a vacuum, and in which the edges of at least one of the layers are defined by an overhang lift-off stencil, the method including the steps of evacuating the chamber containing the device to a high vacuum, admitting inert gas to maintain a pressure lying in the range $1.33 \times 10^{-2}$ to 6.67 Pa ($10^{-4}$ to $5 \times 10^{-2}$ torr), and depositing the stencil-defined layer at that pressure.

2. A method according to claim 1 in which the gas is argon.

3. A method according to claim 2 in which the argon pressure is 0.133 Pa ($10^{-3}$ torr) during the deposition step.

## Patentansprüche

1. Verfahren zum Herstellen einer elektrischen Anordnung durch die Abscheidung von Schichten von Leitern und Isolatoren auf einem Substrat in einem Vakuum, bei dem die Ränger von zumindest einer der Schichten durch eine Überhand-Abhebeschablone definiert werden, wobei das Verfahren folgende Schritte aufweist: Evakuieren der die Anordnung enthaltenden Kammer auf ein Hochvakuum, Zuführen von Edelgas, um einen Druck zu halten, der in dem Bereich von $1,33 \times 10^{-2}$ bis 6,67 Pa ($10^{-4}$ bis $5 \times 10^{-2}$ Torr) liegt, und Abscheiden der Schablonendefinierten Schicht bei diesem Druck.

2. Verfahren nach Anspruch 1, bei dem das Gas Argon ist.

EP 0 090 613 B1

3. Verfahren nach Anspruch 2, bei dem der Argon-Druck während des Abscheideschritts 0,133 Pa ($10^{-3}$ Torr) beträgt.

**Revendications**

1. Procédé de réalisation d'un dispositif électrique par le dépôt de couches de conducteurs et d'isolants sur un substrat sous vide, et dans lequel les bords d'au moins l'une des couches sont définis par un masque à surplomb obtenu par décollement, ledit procédé comportant les étapes consistant à faire de vide dans la chambre renfermant le dispositif jusqu'à l'obtention d'un vide poussé, à faire entrer un gaz inerte pour maintenir une pression situées dans un intervalle de $1,33 \times 10^{-2}$ à $6.67$ Pa (de $10^{-4}$ à $5 \times 10^{-2}$ torr), et à déposer la couche définie par le masque à cette pression.

2. Procédé selon la revendication 1, dans lequel le gaz est de l'argon.

3. Procédé selon la revendication 2, dans lequel la pression de l'argon est de $0.133$ Pa ($10^{-3}$ torr) au cours de l'étape de dépôt.

FIG 1
(PRIOR ART)

FIG 2
(PRIOR ART)

FIG 3
(PRIOR ART)

FIG 4

FIG 5

FIG 6

| PRESS TORR | M.F.P. CM | AVE. COLL. AT 35 CM |
|------------|-----------|---------------------|
| $10^{-6}$ | 5000 | << 1 |
| $10^{-4}$ | 50 | .7 |
| $10^{-3}$ | 5 | 7 |
| $10^{-2}$ | .5 | 70 |
| $3 \times 10^{-2}$ | .167 | 210 |
| $5 \times 10^{-2}$ | .1 | 350 |

FIG 7

.1